(19) **Europäisches Patentamt**
**European Patent Office**
**Office européen des brevets**

(11) **EP 4 764 582 A1**

(12) **EUROPEAN PATENT APPLICATION**
published in accordance with Art. 153(4) EPC

(43) Date of publication:
**24.06.2026 Bulletin 2026/26**

(21) Application number: **25790539.8**

(22) Date of filing: **06.03.2025**

(51) International Patent Classification (IPC):
**G01R 35/00** (2006.01)   **G01R 1/20** (2006.01)
**G01R 31/52** (2020.01)   **G01R 31/389** (2019.01)
**G01R 31/385** (2019.01)   **G01R 31/392** (2019.01)
**G01R 19/00** (2006.01)   **G01R 19/165** (2006.01)
**G01R 19/10** (2006.01)   **G01R 31/367** (2019.01)

(52) Cooperative Patent Classification (CPC):
**G01R 1/20; G01R 19/00; G01R 19/10;
G01R 19/165; G01R 31/367; G01R 31/385;
G01R 31/389; G01R 31/392; G01R 31/52;
G01R 35/00**

(86) International application number:
**PCT/KR2025/003010**

(87) International publication number:
**WO 2025/220879 (23.10.2025 Gazette 2025/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.04.2024 KR 20240052988**

(71) Applicant: **LG Energy Solution, Ltd.**
**Seoul 07335 (KR)**

(72) Inventors:
• **LEE, Wonhoe**
**Daejeon 34122 (KR)**
• **JEONG, Won Jeon**
**Daejeon 34122 (KR)**
• **KIM, Jinny**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT SYSTEM THAT CAN DIAGNOSE SHUNT RESISTOR FAILURE AND METHOD OF DIAGNOSING SHUNT RESISTOR FAILURE USING SAME**

(57)     The present disclosure relates to a battery management system capable of diagnosing a shunt resistor failure, and a method of diagnosing the shunt resistor failure using the same. The battery management system includes a current predictor that receives a voltage of an auxiliary battery from an auxiliary battery voltage measurer, predicts a first current by dividing the voltage of the auxiliary battery by an internal resistance of the auxiliary battery, receives a voltage of a main battery from a main battery voltage measurer, and predicts a second current by dividing the voltage of the main battery by an internal resistance of the main battery, and a state diagnosis part that calculates an average of the first current and the second current, calculates a first error rate based on the average and the auxiliary current, and diagnoses the state of an auxiliary shunt resistor based on the calculated first error rate.

FIG. 1

## Description

**[Technical Field]**

CROSS-REFERENCE TO RELATED APPLICATION

This application claims priority to and the benefit of Korean Patent Application No. 10-2024-0052988 filed at the Korean Intellectual Property Office on April 19, 2024, the entire contents of which are incorporated herein by reference.

The present disclosure relates to a battery management system capable of diagnosing shunt resistor failure and a method of diagnosing shunt resistor failure using the same.

**[Background Art]**

Currently commercially available batteries include nickel cadmium batteries, nickel hydrogen batteries, nickel zinc batteries, and lithium batteries. The power supply system for these batteries may typically have a current sensor to measure current. The current sensor measures a current flowing through a charging/discharging path of the battery to monitor the state of the battery and detect an overcurrent flowing through the battery. Further, the current measured by the current sensor may be utilized as information for calculating an SOC or utilized as a base for determining whether the charging/discharging process is normally performed.

A shunt resistor is used as a component to measure the current flowing through the battery, and the current may be measured by measuring a voltage at both ends of the shunt resistor. However, if the shunt resistor is not functioning properly, the current flowing through the battery cannot be properly measured. As a result, even if an abnormal situation such as an overcurrent occurs, it may not be properly blocked, which may lead to serious problems such as battery failure or explosion.

Conventionally, it is possible to diagnose the state of the shunt resistor by comparing the current value flowing through the shunt resistor with the current prediction value obtained based on the voltage value obtained by a cell voltage measurer. However, when multiple charging/discharging cases are possible, such as charging, discharging, and simultaneous charging/discharging modes-that is, when two shunt resistors are used (for example, when a main shunt resistor and an auxiliary shunt resistor are used together)-the conventional method of diagnosing the state of the shunt resistor can diagnose the state of the auxiliary shunt resistor only when charging is being performed through the charge path and discharging is not being performed through the discharge path. Accordingly, there is a need for a method capable of diagnosing the state of the auxiliary shunt resistor regardless of the charging/discharging mode.

**[Disclosure]**

**[Technical Problem]**

The present disclosure attempts to provide a battery management system capable of diagnosing a shunt resistor failure in a battery system capable of charging, discharging, and charging/discharging modes and including a main shunt resistor and an auxiliary shunt resistor, and a method of diagnosing the shunt resistor failure using the same.

**[Technical Solution]**

According to an embodiment of the present disclosure, a battery management system capable of diagnosing the shunt resistor failure includes an auxiliary current detector that detects an auxiliary current flowing through an auxiliary shunt resistor based on a voltage generated at both ends of the auxiliary shunt resistor, an auxiliary battery voltage measurer connected to positive and negative terminals of an auxiliary battery and measuring the voltage of the auxiliary battery, a main battery voltage measurer connected to the positive and negative terminals of the main battery and measuring the voltage of the main battery, a current predictor that predicts a first current by dividing the voltage of the auxiliary battery measured by the auxiliary battery voltage measurer by internal resistance of the auxiliary battery, and predicts a second current by dividing the voltage of the main battery measured by the main battery voltage measurer by the internal resistance of the main battery, and a state diagnosis part that calculates an average of the first current and the second current, calculates a first error rate based on the average and the auxiliary current, and diagnoses the state of the auxiliary shunt resistor based on the calculated first error rate.

The current predictor may receive the auxiliary current from the auxiliary current detector, and calculate the internal resistance of the auxiliary battery by dividing the voltage of the auxiliary battery by the auxiliary current.

The battery management system may include a main current detector that detects the main current flowing through the main shunt resistor based on the voltage generated at both ends of the main shunt resistor.

The current predictor may receive the main current from the main current detector, and calculate the internal resistance of the main battery by dividing the voltage of the main battery by the main current.

The state diagnosis part may determine whether the auxiliary current is greater than or equal to the reference value, and may determine that the auxiliary shunt resistor is in an open state when the auxiliary current is greater than or equal to the reference value.

The state diagnosis part may determine that the auxiliary shunt resistor is in a short state when the first error rate is greater than or equal to a predetermined threshold value, and determine that the auxiliary shunt resistor is in a drift state when the first error rate is within a predetermined range less than the threshold value.

The state diagnosis part may calculate a second error rate based on the second current and the main current, and diagnose the state of the main shunt resistor based on the calculated second error rate.

The state diagnosis part may determine whether the main current is greater than or equal to the reference value, and determine that the main shunt resistor is in an open state when the main current is greater than or equal to the reference value.

The state diagnosis part may determine that the main shunt resistor is in a short state when the second error rate is greater than or equal to a predetermined threshold value, and determine that the main shunt resistor is in a drift state when the second error rate is within a predetermined range less than the threshold value.

In a battery system including an auxiliary shunt resistor and a main shunt resistor according to an embodiment of the present disclosure, a method of diagnosing an auxiliary shunt resistor failure and a main shunt resistor failure includes an auxiliary current detector detecting an auxiliary current flowing through the auxiliary shunt resistor based on a voltage generated at both ends of the auxiliary shunt resistor, a current predictor predicting a first current by dividing a voltage of an auxiliary battery measured by an auxiliary battery voltage measurer by the internal resistance of the auxiliary battery, and predicts a second current by dividing a voltage of a main battery measured by a main battery voltage measurer by the internal resistance of the main battery, a state diagnosis part calculating an average of the first current and the second current when the auxiliary current is less than the reference value, and calculating a first error rate using the auxiliary current and the average, and the state diagnosis part determining the state of the auxiliary shunt resistor based on the first error rate.

The predicting of the second current may include the current predictor receiving the auxiliary current detected through the auxiliary current detector, and calculating the internal resistance of the auxiliary battery by dividing the voltage of the auxiliary battery by the auxiliary current, and the current predictor receiving a main current detected based on the voltage generated at both ends of the main shunt resistor through a main current detector, and calculating the internal resistance of the main battery by dividing the voltage of the main battery by the main current.

The calculating of the first error rate may include the state diagnosis part determining whether the auxiliary current is greater than or equal to a predetermined reference value, and determining that the auxiliary shunt resistor is in an open state when the auxiliary current is greater than or equal to a predetermined reference value.

The calculating of the first error rate may include calculating a ratio of the difference between the auxiliary current and the average of the first current and the second current to the average of the first current and the second current as the first error rate.

The determining of the state of the auxiliary shunt resistor may include determining whether the first error rate is greater than or equal to a predetermined threshold value, and determining that the auxiliary shunt resistor is in a short state when the first error rate is greater than or equal to the threshold value.

The determining of the state of the auxiliary shunt resistor may include determining whether the first error rate is within a predetermined range less than the threshold value, and determining that the auxiliary shunt resistor is in a drift state when the first error rate is within a predetermined range less than the threshold value.

According to embodiments, the method may further include the main current detector detecting a main current flowing through a main shunt resistor based on a voltage generated at both ends of the main shunt resistor, the current predictor predicting the second current by dividing the voltage of the main battery by the internal resistance of the main battery, the state diagnosis part calculating a second error rate using the main current and the second current, and the state diagnosis part determining the state of the main shunt resistor based on the second error rate.

**[Advantageous Effects]**

According to an embodiment of the present disclosure, in a battery system including both a main shunt resistor and an auxiliary shunt resistor capable of simultaneous charging/discharging, it is possible to accurately diagnose the state of the auxiliary shunt resistor.

Effects that may be obtained from the present disclosure are not limited to only those mentioned above, and other effects which are not described herein will be apparent to those skilled in the art from the following description.

**[Description of the Drawings]**

FIG. 1 illustrates a battery system according to an embodiment of the present disclosure.
FIG. 2 is a block diagram of a battery management system according to an embodiment of the present disclosure.
FIG. 3 is a flowchart of a method of diagnosing an auxiliary shunt resistor failure according to an embodiment of the present disclosure.
FIG. 4 is a flowchart of a method of diagnosing a main shunt resistor failure according to an embodiment of the present disclosure.

**[Mode for Invention]**

When describing the embodiments disclosed in the present disclosure, if it is determined that a detailed description of a related known technology may obscure the gist of the embodiments disclosed in this specification, such a detailed description is omitted. The accompanying drawings are intended only to facilitate understanding of the exemplary embodiments disclosed in this specification, and it is to be understood that the technical ideas disclosed herein are not limited by the accompanying drawings and include all modifications, equivalents, or substitutions that are within the range of the ideas and technology of the present disclosure.

Although the terms "first," "second," and the like are used to explain various components, the components are not limited to such terms. These terms are only used to distinguish one component from another component.

It is to be understood that when one component is referred to as being "connected" or "coupled" to another component, it may be connected or coupled directly to another component or there may be other intervening components. On the other hand, it is to be understood that when one component is referred to as being "connected or coupled directly" to another component, there are no other intervening components.

Throughout the specification, the terms "comprise" and "have" are intended to specify the presence of stated features, integers, steps, operations, components, or a combination thereof, but do not preclude the presence or addition of one or more other features, integers, steps, operations, components, or combinations thereof.

Hereinafter, the present disclosure is described in detail with reference to the attached drawings.

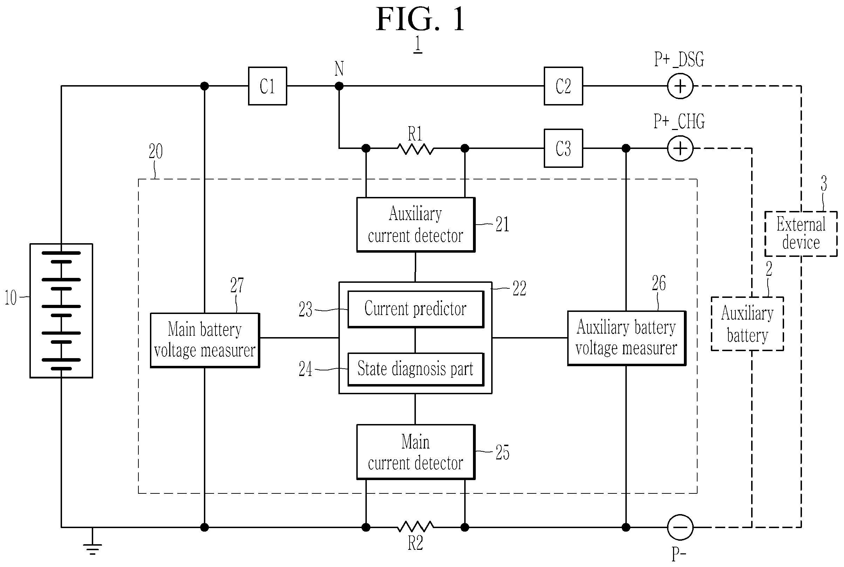

FIG. 1 illustrates a battery system 1 according to an embodiment of the present disclosure.

Referring to FIG. 1, a battery system 1 according to an embodiment of the present disclosure may include a main battery 10, an auxiliary battery 2, contactors C1 to C3, a main shunt resistor R2, an auxiliary shunt resistor R1, and a battery management system 20.

In FIG. 1, the main battery 10 is connected between a node N connecting a first power terminal P+_DSG and a second power terminal P+_CHG of the battery system 1 and a third power terminal P-. A first contactor C1 may be connected between the positive electrode of the main battery 10 and the node N, a second contactor C2 may be connected between the node N and the first power terminal P+_DSG, and the auxiliary shunt resistor R1 and a third contactor C3 may be connected between the node N and the second power terminal P+_CHG. The main shunt resistor R2 is connected between the negative electrode of the main battery 10 and the third power terminal P-, and grounding may be provided. In the present disclosure, the potential of the positive electrode is higher than the potential of the negative electrode.

The main battery 10 is a rechargeable battery capable of charging, discharging, and charging/discharging. According to an embodiment, the main battery 10 may include a plurality of battery cells electrically connected in series and in parallel.

The auxiliary battery 2 is a charger that supplies power to the main battery 10 to charge it. According to an embodiment, the auxiliary battery 2 may include a plurality of battery cells electrically connected in series and in parallel, and may be a rechargeable battery capable of charging and discharging. The electrical connection between the auxiliary battery 2 and the main battery 10 is controlled through the ON/OFF operations of the first contactor C1 and the third contactor C3.

The contactors C1 to C3 act as a kind of switch that controls the connection between the main battery 10 and the auxiliary battery 2 and the connection between the main battery 10 and an external device 3. For example, in FIG. 1, when the first contactor C1 and the third contactor C3 are turned on, the main battery 10 and the auxiliary battery 2 are electrically connected and charging of the main battery 10 is performed, and when the first contactor C1 and the second contactor C2 are turned on, the main battery 10 and the external device 3 are connected and discharging of the main battery 10 is performed. In this case, the external device 3 may be a load such as a vehicle. According to an embodiment, the contactor may include the first to third contactors C1 to C3, and the first to third contactors C1 to C3 may be relays or MOSFETs.

The main shunt resistor R2 is a shunt resistor element for detecting current flowing through a specific point in the battery system 1 when the main battery 10 is being charged and/or discharged. According to an embodiment, the main shunt resistor R2 may detect a current flowing between the negative electrode of the main battery 10 and the third power terminal P- when the main battery 10 is being discharged by the external device 3-i.e., when a discharging cycle is in progress-according to the ON operation of the first contactor C1 and the second contactor C2. In addition, the main shunt resistor R2 may detect the current flowing between the negative electrode of the main battery 10 and the third power terminal P- when the main battery 10 is being charged by the auxiliary battery 2-i.e., when a charging cycle is in progress-according to the ON operation of the first contactor C1 and the third contactor C3. In FIG. 1, the main shunt resistor R2 is illustrated as being connected between the negative electrode of the main battery 10 and the third power terminal P-, but the location where the main shunt resistor R2 is connected is not limited thereto, and may be freely changed as long as the current flowing in the main battery 10 during charging and/or discharging of the main battery 10 may be measured.

The auxiliary shunt resistor R1 is a shunt resistor element for detecting the current flowing through a specific point in the battery system 1 when the main battery 10 is being charged. According to an embodiment, the auxiliary shunt resistor R1 may detect a current flowing between the node N and the third contactor C3 when the main battery 10 is being charged by the auxiliary battery 2-i.e., when a charging cycle is in progress-according to the ON operation of the first contactor C1 and the third contactor C3. In FIG. 1, the auxiliary shunt resistor R1 is shown as being connected between the node N and the third contactor C3, but the location where the auxiliary shunt resistor R1 is connected is not limited thereto, and may be freely changed as long as the current flowing through the auxiliary battery 2 during charging of the main battery 10 may be measured.

The battery management system 20 (BMS) may include an auxiliary current detector 21, a controller 22, an auxiliary battery voltage measurer 26, and a main battery voltage measurer 27. Here, the controller 22 may include a current predictor 23 and a state diagnosis part 24. According to an embodiment, the battery management system 20 may further include a main current detector 25.

The auxiliary current detector 21, the main current detector 25, the auxiliary battery voltage measurer 26, and the main battery voltage measurer 27 may transmit and receive signals with the controller 22 through wired or wireless communication methods. For example, the controller 22 may generate a control signal and transmit the control signal to each of the auxiliary current detector 21, the main current detector 25, the auxiliary battery voltage measurer 26, and the main battery voltage measurer 27, and the auxiliary current detector 21, the main current detector 25, the auxiliary battery voltage measurer 26, and the main battery 10 measurer may detect or measure the auxiliary current, the main current, the voltage of the auxiliary battery 2, and the voltage of the main battery 10, respectively, according to the control signal. In addition, the auxiliary current detector 21 may detect the auxiliary current and transmit it to the controller 22, and the main current detector 25 may detect the main current and transmit it to the controller 22. In addition, the auxiliary battery voltage measurer 26 may measure the voltage of the auxiliary battery 2 and transmit it to the controller 22, and the main battery voltage measurer 27 may measure the voltage of the main battery 10 and transmit it to the controller 22.

That is, the battery management system 20 may measure the voltage, current, temperature, etc. of the main battery 10 and may measure the voltage, current, temperature, etc. of the auxiliary battery 2. Additionally, the battery management system 20 may diagnose the state of the main shunt resistor R2 and the auxiliary shunt resistor R1 using the voltage, current, and temperature of the main battery 10 and the voltage, current, and temperature of the auxiliary battery 2.

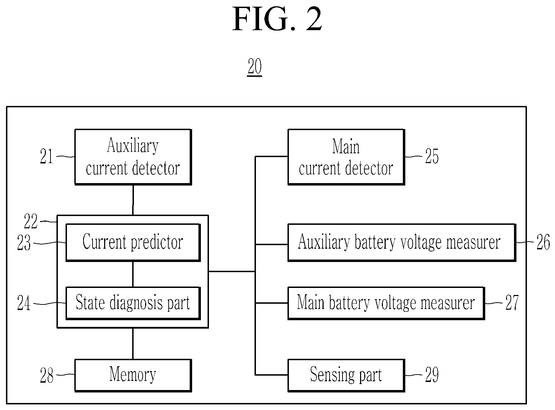

The battery management system 20 according to an embodiment of the present disclosure will be described in detail with reference to FIG. 2 below.

FIG. 2 is a block diagram of the battery management system 20 according to an embodiment of the present disclosure.

Referring to FIGS. 1 and 2, the auxiliary current detector 21 detects the auxiliary current flowing through the auxiliary shunt resistor R1 based on the voltage generated at both ends of the auxiliary shunt resistor R1. For example, the auxiliary current detector 21 may measure the voltage generated at both ends of the auxiliary shunt resistor and divide the measured voltage value by the resistance value of the auxiliary shunt resistor R1 to detect the auxiliary current flowing through the auxiliary shunt resistor R1. In this case, the resistance value of the auxiliary shunt resistor R1 may be stored in a memory 28 or the auxiliary current detector 21 as a value known in advance.

The main current detector 25 detects the main current flowing through the main shunt resistor R2 based on the voltage generated at both ends of the main shunt resistor R2. For example, the main current detector 25 may measure the voltage generated at both ends of the main shunt resistor and divide the measured voltage value by the resistance value of the main shunt resistor R2 to detect the main current flowing through the main shunt resistor R2. In this case, the resistance value of the main shunt resistor R2 may be stored in the memory 28 or the main current detector 25 as a value known in advance.

The auxiliary battery voltage measurer 26 is connected to the positive and negative terminals of the auxiliary battery 2 and measures the voltage of the auxiliary battery 2. Here, the voltage of the auxiliary battery 2 refers to the voltage difference between the positive and negative terminals of the auxiliary battery 2.

The main battery voltage measurer 27 is connected to the positive and negative terminals of the main battery 10 and measures the voltage of the main battery 10. Here, the voltage of the main battery 10 means the voltage difference between the positive and negative terminals of the main battery 10.

The current predictor 23 may predict a first current using the voltage and internal resistance of the auxiliary battery 2, and may predict a second current using the voltage and internal resistance of the main battery 10. For example, the current predictor 23 may predict the first current by dividing the voltage of the auxiliary battery 2 measured by the auxiliary battery voltage measurer 26 by the internal resistance of the auxiliary battery 2. The current predictor 23 may predict the second current by dividing the voltage of the main battery 10 measured by the main battery voltage measurer 27 by the internal resistance of the main battery 10.

At this time, the voltage of the auxiliary battery 2 is received from the auxiliary battery voltage measurer 26, and the voltage of the main battery 10 is received from the main battery voltage measurer 27. According to an embodiment, the internal resistance of the auxiliary battery 2 and the internal resistance of the main battery 10 may be data recorded in the memory 28 or values calculated by the current predictor 23.

For example, the current predictor 23 may receive the auxiliary current from the auxiliary current detector 21 and the voltage of the auxiliary battery 2 from the auxiliary battery voltage measurer 26, and then divide the voltage of the auxiliary battery 2 by the auxiliary current to calculate the internal resistance of the auxiliary battery 2. Alternatively, the current predictor 23 may receive the temperature measurement value of the auxiliary battery 2 measured by a sensing part 29, detect the internal resistance of the auxiliary battery 2 according to the temperature measurement value from the table stored in the memory 28, and determine it as the internal resistance of the auxiliary battery 2. In this case, a table listing the internal resistance values according to the temperature value of the auxiliary battery 2 may be stored in the memory 28.

For example, the current predictor 23 may receive the main current from the main current detector 25 and the voltage of the main battery 10 from the main battery voltage measurer 27, and then divide the voltage of the main battery 10 by the main current to calculate the internal resistance of the main battery 10. Alternatively, the current predictor 23 may receive the temperature measurement value of the main battery 10 measured by the sensing part 29, detect the internal resistance of the main battery 10 according to the temperature measurement value from the table stored in the memory 28, and determine it as the internal resistance of the main battery 10. In this case, the table listing the internal resistance values according to the temperature value of the main battery 10 may be stored in the memory 28.

The state diagnosis part 24 may calculate the average of the first current and the second current, and use this to calculate a first error rate.

Here, the first error rate corresponds to a reference used to diagnose the state of the auxiliary shunt resistor R1, and the state diagnosis part 24 may derive the first error rate using the auxiliary current and the average value of the first current and the second current. For example, the state diagnosis part 24 may calculate the ratio of the difference between the auxiliary current and the average of the first and second currents to the average of the first current and the second current as the first error rate, as shown in Equation 1.

(Equation 1)

$$\text{First error rate } (\%) = \frac{|\text{Auxiliary current} - \text{ Average of first current and second current}|}{\text{Average of first current and second current}} \times 100$$

The state diagnosis part 24 may determine the state of the auxiliary shunt resistor R1 based on the first error rate. For example, the state diagnosis part 24 may determine whether the auxiliary current is greater than or equal to the reference value, and if the auxiliary current is greater than or equal to the reference value, determine that the auxiliary shunt resistor R1 is in an open state. The reference value may be determined based on the current range that the auxiliary current may have and the value of the auxiliary shunt resistance in the open state.

In addition, the state diagnosis part 24 may determine whether the first error rate is greater than or equal to a predetermined threshold value, and may determine that the auxiliary shunt resistor R1 is in a short state when the first error rate is greater than or equal to the threshold value. The threshold value may be set to any value within the range from 100% to a ratio minus a specified margin based on 100%. In addition, the state diagnosis part 24 may determine whether the first error rate is within a predetermined range less than the threshold value, and may determine that the auxiliary shunt resistor R1 is in a drift state when the first error rate is within the predetermined range. The predetermined range may be determined based on the ranges that each of the first current, the second current, and the auxiliary current has in the drift state of the auxiliary shunt resistor R1.

According to an embodiment, the state diagnosis part 24 may calculate the second error rate based on the second current and the main current.

Here, the second error rate corresponds to a reference used to diagnose the state of the main shunt resistor R2, and the state diagnosis part 24 may derive the second error rate using the main current and the second current. For example, the state diagnosis part 24 may calculate the ratio of the difference between the main current and the second current to the second current as the second error rate, as in Equation 2.

(Equation 2)

$$\text{Second error rate } (\%) = \frac{|\text{Main current} - \text{Second current}|}{\text{Second current}} \times 100$$

According to an embodiment, the state diagnosis part 24 may diagnose the state of the main shunt resistor R2 based on the second error rate. For example, the state diagnosis part 24 may determine whether the main current is greater than or equal to a reference value, and may determine that the main shunt resistor R2 is in an open state when the main current is greater than or equal to the reference value. The reference value may be determined based on the current range that the main current may have and the value of the main shunt resistor R2 in the open state.

In addition, the state diagnosis part 24 may determine whether the second error rate is greater than or equal to a predetermined threshold value, and may determine that the main shunt resistor R2 is in a short state when the second error rate is greater than or equal to the threshold value. The threshold value may be set to any value within the range from 100% to a ratio minus a specified margin based on 100%. In addition, the state diagnosis part 24 may determine whether the second error rate is within a predetermined range less than the threshold value, and may determine that the main shunt resistor R2 is in a drift state when the second error rate is within the predetermined range. The predetermined range may be determined based on the range that each of the main current and the second current has in the drift state of the main shunt resistor R2.

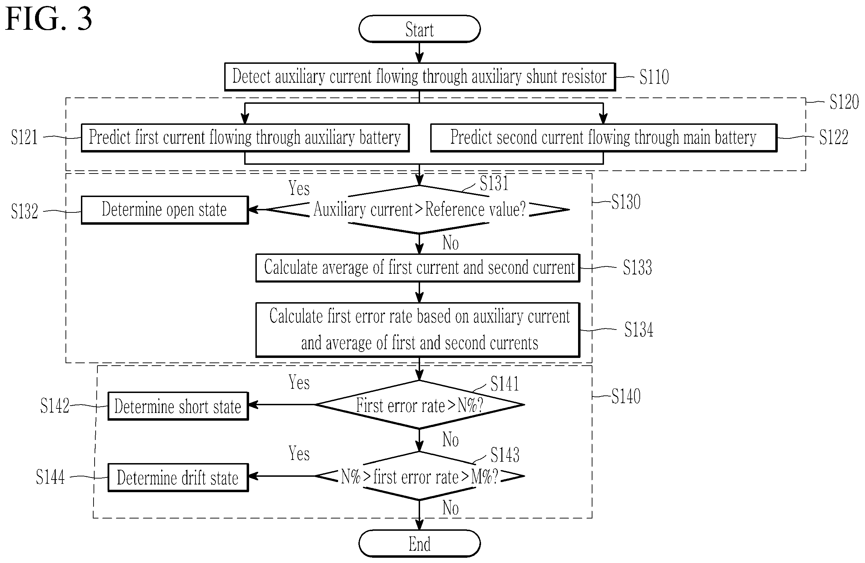

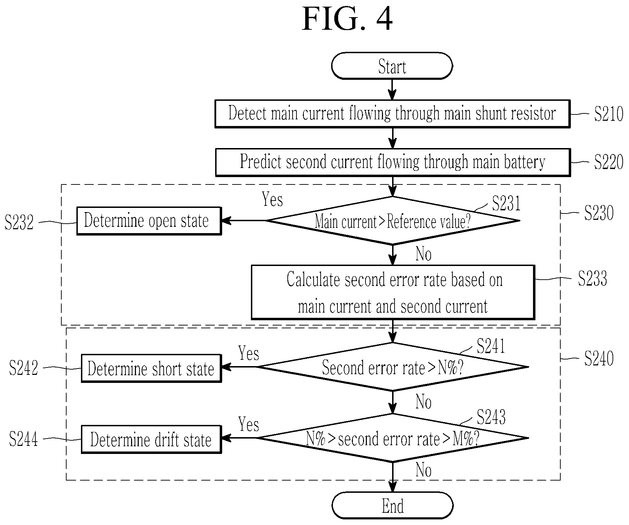

FIG. 3 is a flowchart of a method of diagnosing the auxiliary shunt resistor R1 failure according to an embodiment of the present disclosure, and FIG. 4 is a flowchart of a method of diagnosing the main shunt resistor R2 failure according to an embodiment of the present disclosure.

Referring to FIGS. 3 and 4, a method of diagnosing the shunt resistor failure according to an embodiment of the present disclosure may include a method of diagnosing the auxiliary shunt resistor R1 failure and/or a method of diagnosing the main shunt resistor R2 failure. That is, a method according to an embodiment of the present disclosure may diagnose the state of the auxiliary shunt resistor R1 and/or the main shunt resistor R2 in the battery system 1 including the auxiliary shunt resistor R1 and the main shunt resistor R2.

Referring to FIG. 3, the method of diagnosing the auxiliary shunt resistor R1 failure according to an embodiment of the present disclosure may include an auxiliary current detection step (S110), a current prediction step (S120), an error rate calculation step (S130), and a state diagnosis step (S140).

In the auxiliary current detection step (S110), the auxiliary current detector 21 detects the auxiliary current flowing through the auxiliary shunt resistor R1 based on the voltage generated at both ends of the auxiliary shunt resistor R1. In this case, the detected auxiliary current may be transmitted to the controller 22.

In the current prediction step (S120), the current predictor 23 predicts the first current and the second current using the voltage and internal resistance of the auxiliary battery 2 and the voltage and internal resistance of the main battery 10, respectively. For example, the current predictor 23 may predict the first current by dividing the voltage of the auxiliary battery 2 measured by the auxiliary battery voltage measurer 26 by the internal resistance of the auxiliary battery 2 (S121). The current predictor 23 may predict the second current by dividing the voltage of the main battery 10 measured by the main battery voltage measurer 27 by the internal resistance of the main battery 10 (S122).

According to an embodiment, the internal resistance of the auxiliary battery 2 may be derived using the auxiliary current or the temperature measurement value of the auxiliary battery 2. For example, the current predictor 23 may receive the auxiliary current from the auxiliary current detector 21 and the voltage of the auxiliary battery 2 from the auxiliary battery voltage measurer 26, and then divide the voltage of the auxiliary battery 2 by the auxiliary current to calculate the internal resistance of the auxiliary battery 2. In addition, the current predictor 23 may receive the temperature measurement value of the auxiliary battery 2 measured by the sensing part 29, detect the internal resistance of the auxiliary battery 2 according to the temperature measurement value from the table stored in the memory 28, and determine it as the internal resistance of the auxiliary battery 2. In this case, the table listing the internal resistance values according to the temperature value of the auxiliary battery 2 may be stored in the memory 28.

According to an embodiment, the internal resistance of the main battery 10 may be derived using the main current or the temperature measurement value of the main battery 10. For example, the current predictor 23 may receive the main current from the main current detector 25 and the voltage of the main battery 10 from the main battery voltage measurer 27, and then divide the voltage of the main battery 10 by the main current to calculate the internal resistance of the main battery 10. Here, the main current may be detected based on the voltage generated at both ends of the main shunt resistor R2 by the main current detector 25. In addition, the current predictor 23 may receive the temperature measurement value of the main battery 10 measured by the sensing part 29, detect the internal resistance of the main battery 10 according to the temperature measurement value from the table stored in the memory 28, and determine it as the internal resistance of the main battery 10. In this case, the table listing the internal resistance values according to the temperature value of the main battery 10 may be stored in the memory 28.

In the error rate calculation step (S130), the state diagnosis part 24 may calculate the average of the first current and the second current (S133), and the state diagnosis part 24 may calculate the first error rate using the auxiliary current and the average of the first and second currents (S134). In this case, the state diagnosis part 24 may receive the first current and the second current from the current predictor 23 and the auxiliary current from the auxiliary current detector 21.

Here, the first error rate corresponds to a reference used to diagnose the state of the auxiliary shunt resistor R1, and the state diagnosis part 24 may derive the first error rate using the auxiliary current and the average value of the first current and the second current. For example, the state diagnosis part 24 may calculate the ratio of the difference between the auxiliary current and the average of the first and second currents to the average of the first and second currents as the first error rate.

According to an embodiment, in the error rate calculation step (S130), the state diagnosis part 24 may determine whether the auxiliary current is greater than or equal to a reference value (S131). In this case, when the auxiliary current is greater than or equal to the predetermined reference value, the state diagnosis part 24 may determine that the auxiliary shunt resistor R1 is in an open state (S132). In other words, when the auxiliary current is greater than or equal to the predetermined reference value, the state diagnosis part 24 may diagnose the state of the auxiliary shunt resistor R1 without calculating the first error rate.

In the state diagnosis step (S140), the state diagnosis part 24 may determine the state of the auxiliary shunt resistor R1 based on the first error rate.

According to an embodiment, the state diagnosis step (S140) may include short determination steps (S141 and S142) and drift determination steps (S143 and S144). For example, in the state diagnosis step (S140), the state diagnosis part 24 may determine whether the auxiliary shunt resistor R1 is in a short state through the step (S141) of determining whether the first error rate is greater than or equal to a predetermined threshold value, and the step (S142) of determining that the auxiliary shunt resistor R1 is in a short state when the first error rate is greater than or equal to the predetermined threshold value. In addition, in the state diagnosis step (S140), the state diagnosis part 24 may determine whether the auxiliary shunt resistor R1 is in a drift state through the step (S143) of determining whether the first error rate is within a predetermined range less than the threshold value, and the step (S144) of determining that the auxiliary shunt resistor R1 is in a drift state when the first error rate is within a predetermined range less than the threshold value.

FIG. 4 is a flowchart of the method of diagnosing the main shunt resistor R2 failure according to an embodiment of the present disclosure.

Referring to FIG. 4, the method of diagnosing the main shunt resistor R2 failure according to an embodiment of the present disclosure may include a main current detection step (S210), a current prediction step (S220), an error rate calculation step (S230), and a state diagnosis step (S240).

In the main current detection step (S210), the main current detector 25 detects the main current flowing through the main shunt resistor R2 based on the voltage generated at both ends of the main shunt resistor R2. In this case, the detected main current may be transmitted to the controller 22.

In the current prediction step (S220), the current predictor 23 predicts the second current using the voltage and internal resistance of the main battery 10. For example, the current predictor 23 may predict the second current by dividing the voltage of the main battery 10 measured by the main battery voltage measurer 27 by the internal resistance of the main battery 10 (S220).

According to an embodiment, the internal resistance of the main battery 10 may be derived using the main current or the temperature measurement value of the main battery 10. For example, the current predictor 23 may receive the main current from the main current detector 25 and the voltage of the main battery 10 from the main battery voltage measurer 27, and then divide the voltage of the main battery 10 by the main current to calculate the internal resistance of the main battery 10. In addition, the current predictor 23 may receive the temperature measurement value of the main battery 10 measured by the sensing part 29, detect the internal resistance of the main battery 2 according to the temperature measurement value from the table stored in the memory 28, and determine it as the internal resistance of the main battery 10. In this case, the table listing the internal resistance values according to the temperature value of the main battery 10 may be stored in the memory 28.

In the error rate calculation step (S230), the state diagnosis part 24 may calculate the second error rate using the second current and the main current (S233). In this case, the state diagnosis part 24 may receive the second current from the current predictor 23 and the main current from the main current detector 25.

Here, the second error rate corresponds to a reference used to diagnose the state of the main shunt resistor R2, and the state diagnosis part 24 may derive the second error rate using the main current and the second current. For example, the state diagnosis part 24 may calculate the ratio of the difference between the main current and the second current to the second current as the second error rate.

According to an embodiment, in the error rate calculation step (S230), the state diagnosis part 24 may determine whether the main current is greater than or equal to a reference value (S231). In this case, when the main current is greater than or equal to the predetermined reference value, the state diagnosis part 24 may determine that the main shunt resistor R2 is in an open state (S232). In other words, when the main current is greater than or equal to the predetermined reference value, the state diagnosis part 24 may diagnose the state of the main shunt resistor R2 without calculating the second error rate.

In the state diagnosis step (S240), the state diagnosis part 24 may determine the state of the main shunt resistor R2 based on the second error rate.

According to an embodiment, the state diagnosis step (S240) may include short determination steps (S241 and S242) and drift determination steps (S243 and S244). For example, in the state diagnosis step (S240), the state diagnosis part 24 may determine whether the main shunt resistor R2 is in a short state through the step (S241) of determining whether the second error rate is greater than or equal to a predetermined threshold value, and the step (S242) of determining that the main shunt resistor R2 is in a short state when the second error rate is greater than or equal to the predetermined threshold value. In addition, in the state diagnosis step (S240), the state diagnosis part 24 may determine whether the main shunt resistor R2 is in a drift state through the step (S243) of determining whether the second error rate is within a predetermined range less than the threshold value, and the step (S244) of determining that the main shunt resistor R2 is in a drift state when the second error rate is within a predetermined range less than the threshold value.

On the other hand, the above-described method may be written as a program that may be executed on a computer, and may be implemented in a general-purpose digital computer that operates the program using a computer-readable recording medium. The computer-readable recording medium may include a storage medium such as a magnetic storage medium such as a ROM, a RAM, a USB, a floppy disk, or a hard disk, or an optical readable medium such as a CD-ROM or a DVD.

The scope of the present disclosure is defined by the following claims rather than by the detailed description of the embodiments, and it should be understood that all modifications and embodiments conceived from the meaning and scope of the claims and their equivalents are included in the scope of the present disclosure.

**Claims**

**1.** A battery management system, comprising:

an auxiliary current detector that detects an auxiliary current flowing through an auxiliary shunt resistor based on a voltage generated at both ends of the auxiliary shunt resistor;
an auxiliary battery voltage measurer connected to positive and negative terminals of an auxiliary battery and measuring the voltage of the auxiliary battery;
a main battery voltage measurer connected to positive and negative terminals of a main battery and measuring the voltage of the main battery;
a current predictor that predicts a first current by dividing the voltage of the auxiliary battery measured by the auxiliary battery voltage measurer by the internal resistance of the auxiliary battery, and predicts a second current by dividing the voltage of the main battery measured by the main battery voltage measurer by the internal resistance of the main battery; and
a state diagnosis part that calculates an average of the first current and the second current, calculates a first error rate based on the average and the auxiliary current, and diagnoses the state of the auxiliary shunt resistor based on the calculated first error rate.

**2.** The battery management system of claim 1, wherein

the current predictor
receives the auxiliary current from the auxiliary current detector, and calculates the internal resistance of the auxiliary battery by dividing the voltage of the auxiliary battery by the auxiliary current.

**3.** The battery management system of claim 1, comprising:
a main current detector that detects a main current flowing through a main shunt resistor based on a voltage generated at both ends of the main shunt resistor.

**4.** The battery management system of claim 3, wherein

the current predictor

receives the main current from the main current detector, and calculates the internal resistance of the main battery by dividing the voltage of the main battery by the main current.

5. The battery management system of claim 1, wherein

the state diagnosis part
determines whether the auxiliary current is greater than or equal to a reference value, and determines that the auxiliary shunt resistor is in an open state when the auxiliary current is greater than or equal to the reference value.

6. The battery management system of claim 1, wherein

the state diagnosis part
determines that the auxiliary shunt resistor is in a short state when the first error rate is greater than or equal to a predetermined threshold value, and determines that the auxiliary shunt resistor is in a drift state when the first error rate is within a predetermined range less than the threshold value.

7. The battery management system of claim 3, wherein

the state diagnosis part
calculates a second error rate based on the second current and the main current, and diagnoses the state of the main shunt resistor based on the calculated second error rate.

8. The battery management system of claim 7, wherein

the state diagnosis part
determines whether the main current is greater than or equal to a reference value, and determines that the main shunt resistor is in an open state when the main current is greater than or equal to the reference value.

9. The battery management system of claim 7, wherein

the state diagnosis part
determines that the main shunt resistor is in a short state when the second error rate is greater than or equal to a predetermined threshold value, and determines that the main shunt resistor is in a drift state when the second error rate is within a predetermined range less than the threshold value.

10. A method of diagnosing an auxiliary shunt resistor failure and a main shunt resistor failure in a battery system including the auxiliary shunt resistor and the main shunt resistor, comprising:

an auxiliary current detector detecting an auxiliary current flowing through the auxiliary shunt resistor based on a voltage generated at both ends of the auxiliary shunt resistor;
a current predictor predicting a first current by dividing a voltage of an auxiliary battery measured by an auxiliary battery voltage measurer by the internal resistance of the auxiliary battery, and predicting a second current by dividing a voltage of a main battery measured by a main battery voltage measurer by the internal resistance of the main battery;
a state diagnosis part calculating an average of the first current and the second current when the auxiliary current is less than the reference value, and calculating a first error rate using the auxiliary current and the average; and
the state diagnosis part determining the state of the auxiliary shunt resistor based on the first error rate.

11. The method of claim 10, wherein
the predicting of the second current comprises:

the current predictor receiving the auxiliary current detected through the auxiliary current detector, and calculating the internal resistance of the auxiliary battery by dividing the voltage of the auxiliary battery by the auxiliary current; and
the current predictor receiving a main current detected based on the voltage generated at both ends of the main shunt resistor through a main current detector, and calculating the internal resistance of the main battery by dividing the voltage of the main battery by the main current.

12. The method of claim 10, wherein
the calculating of the first error rate comprises:

the state diagnosis part determining whether the auxiliary current is greater than or equal to a predetermined reference value; and
determining that the auxiliary shunt resistor is in an open state when the auxiliary current is greater than or equal to a predetermined reference value.

13. The method of claim 10, wherein

the calculating of the first error rate comprises
calculating a ratio of the difference between the auxiliary current and the average of the first current and the second current to the average of the first current and the second current as the first error rate.

14. The method of claim 10, wherein
the determining of the state of the auxiliary shunt resistor comprises:

determining whether the first error rate is greater than or equal to a predetermined threshold value; and
determining that the auxiliary shunt resistor is in a short state when the first error rate is greater than or equal to the threshold value.

15. The method of claim 10, wherein
the determining of the state of the auxiliary shunt resistor comprises:

determining whether the first error rate is within a predetermined range less than the threshold value; and
determining that the auxiliary shunt resistor is in a drift state when the first error rate is within a predetermined range less than the threshold value.

16. The method of claim 10, further comprising:

the main current detector detecting a main current flowing through a main shunt resistor based on a voltage generated at both ends of the main shunt resistor;
the current predictor predicting the second current by dividing the voltage of the main battery by the internal resistance of the main battery;
the state diagnosis part calculating a second error rate using the main current and the second current; and
the state diagnosis part determining the state of the main shunt resistor based on the second error rate.

## FIG. 1

# FIG. 2

20

| 21 — Auxiliary current detector | | Main current detector — 25 |

| 22 — 23 — Current predictor | | Auxiliary battery voltage measurer — 26 |

| 24 — State diagnosis part | | Main battery voltage measurer — 27 |

| 28 — Memory | | Sensing part — 29 |

**FIG. 3**

Start

Detect auxiliary current flowing through auxiliary shunt resistor — S110

S120

S121 — Predict first current flowing through auxiliary battery          Predict second current flowing through main battery — S122

Yes                    S131
S132 — Determine open state ← Auxiliary current > Reference value? — S130

No

Calculate average of first current and second current — S133

Calculate first error rate based on auxiliary current and average of first and second currents — S134

Yes                    S141
S142 — Determine short state ← First error rate > N%? — S140

No
S143
Yes
S144 — Determine drift state ← N% > first error rate > M%?

No

End

# FIG. 4

```
                          ┌─────────┐
                          │  Start  │
                          └─────────┘
                               │
                               ▼
        ┌──────────────────────────────────────────────┐
        │ Detect main current flowing through main      │──── S210
        │ shunt resistor                                │
        └──────────────────────────────────────────────┘
                               │
                               ▼
        ┌──────────────────────────────────────────────┐
        │ Predict second current flowing through main   │──── S220
        │ battery                                        │
        └──────────────────────────────────────────────┘
                               │
                               ▼
```

┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐

S232 — Determine open state ◄── Yes ── ◇ Main current>Reference value? ◇ ── S231 ── S230

                                         │ No
                                         ▼

                    ┌──────────────────────────────────┐
S233                │ Calculate second error rate based │
                    │ on main current and second current│
                    └──────────────────────────────────┘

└ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘

┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐

S242 — Determine short state ◄── Yes ── ◇ Second error rate>N%? ◇ ── S241 ── S240

                                         │ No
                                         ▼

S244 — Determine drift state ◄── Yes ── ◇ N%>second error rate>M%? ◇ ── S243

                                         │ No
                                         ▼

└ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘

```
                          ┌─────────┐
                          │   End   │
                          └─────────┘
```

## INTERNATIONAL SEARCH REPORT

| International application No. |
| --- |
| **PCT/KR2025/003010** |

| A. | CLASSIFICATION OF SUBJECT MATTER |
| --- | --- |

**G01R 35/00**(2006.01)i; **G01R 1/20**(2006.01)i; **G01R 31/52**(2020.01)i; **G01R 31/389**(2019.01)i; **G01R 31/385**(2019.01)i; **G01R 31/392**(2019.01)i; **G01R 19/00**(2006.01)i; **G01R 19/165**(2006.01)i; **G01R 19/10**(2006.01)i; **G01R 31/367**(2019.01)i

According to International Patent Classification (IPC) or to both national classification and IPC

| B. | FIELDS SEARCHED |
| --- | --- |

Minimum documentation searched (classification system followed by classification symbols)

G01R 35/00(2006.01); G01R 19/00(2006.01); G01R 19/165(2006.01); G01R 31/00(2006.01); G01R 31/36(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 션트(shunt), 저항(resistance), 이상(abnormality), 진단(diagnosis)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-2023-0055178 A (LG ENERGY SOLUTION, LTD.) 25 April 2023 (2023-04-25)<br>See paragraphs [0022], [0030], [0047] and [0071]; and claims 1 and 11. | 1-16 |
| A | KR 10-2013-0137389 A (LG CHEM, LTD.) 17 December 2013 (2013-12-17)<br>See paragraphs [0009]-[0020]. | 1-16 |
| A | JP 2020-051863 A (TOYOTA IND. CO.) 02 April 2020 (2020-04-02)<br>See paragraphs [0010]-[0016]. | 1-16 |
| A | KR 10-2019-0101635 A (LG CHEM, LTD.) 02 September 2019 (2019-09-02)<br>See paragraphs [0013]-[0019]. | 1-16 |
| A | KR 10-2019-0075609 A (LG CHEM, LTD.) 01 July 2019 (2019-07-01)<br>See paragraphs [0014]-[0019]. | 1-16 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 June 2025** | **16 June 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/003010**

| Patent document cited in search report | | | Publication date (day/month/year) | Patent family member(s) | | | Publication date (day/month/year) |
|---|---|---|---|---|---|---|---|
| KR | 10-2023-0055178 | A | 25 April 2023 | None | | | |
| KR | 10-2013-0137389 | A | 17 December 2013 | KR | 10-1473397 | B1 | 16 December 2014 |
| JP | 2020-051863 | A | 02 April 2020 | None | | | |
| KR | 10-2019-0101635 | A | 02 September 2019 | KR 10-2019-0101635 | | A | 02 September 2019 |
| KR | 10-2019-0075609 | A | 01 July 2019 | KR | 10-2055850 | B1 | 13 December 2019 |
| | | | | US | 10545185 | B2 | 28 January 2020 |
| | | | | US | 2019-0195942 | A1 | 27 June 2019 |

Form PCT/ISA/210 (patent family annex) (July 2022)

**EP 4 764 582 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240052988